(19) Europäisches Patentamt
European Patent Office
Office européen des brevets

(11) **EP 4 350 966 A1**

(12) **EUROPEAN PATENT APPLICATION**

(43) Date of publication:
**10.04.2024 Bulletin 2024/15**

(21) Application number: **22199709.1**

(22) Date of filing: **05.10.2022**

(51) International Patent Classification (IPC):
**H02M 3/156** (2006.01)   **H02M 1/42** (2007.01)
**H02M 1/32** (2007.01)   **H03K 5/156** (2006.01)

(52) Cooperative Patent Classification (CPC):
**H02M 3/156; H02M 1/32; H02M 1/4225;**
H03K 5/1565

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Infineon Technologies Austria AG
9500 Villach (AT)**

(72) Inventor: **POON, Hung Piu
Tsuen Wan (HK)**

(74) Representative: **Westphal, Mussgnug & Partner,
Patentanwälte mbB
Werinherstraße 79
81541 München (DE)**

(54) **SWITCHING CONVERTER USING PARTIAL POWER PROCESSING**

(57)    A method for an AC/DC converter is described herein. In accordance with one embodiment, the method includes determining duty cycle values for pulse width modulation (PWM) of a switching signal to operate the AC/DC converter with Power Factor Correction. Thereby, one duty cycle value is determined in each PWM cycle based on a measured current value that has been corrected using an offset value. The method further includes accumulating the duty cycle values throughout a positive half-wave of an AC input voltage of the AC/DC converter to obtain a first sum value and accumulating the duty cycle values throughout a negative half-wave of the AC input voltage of the AC/DC converter to obtain a second sum value. Furthermore, the method includes determining an error value representing the difference between the first sum value and the second sum value and adjusting the offset value based on the error value. Moreover, a corresponding circuit arrangement is described herein.

FIG. 7

**EP 4 350 966 A1**

**Description**

**TECHNICAL FIELD**

The present disclosure relates to the field of switching converters, in particular to AC/DC converters with power factor correction (PFC).

**BACKGROUND**

AC/DC converters with power factor correction (PFC) is a common application for switching converters. PFC is needed to reduce the reactive power (i.e. to improve the power factor) by controlling the input current such that its sinusoidal waveform approximately corresponds to the sinusoidal waveform of the input voltage with a very small (ideally zero) phase shift between input current and input voltage. For this purpose, accurate current sensing needs to be implemented in the AD/DC converter in order to allow a precise input current control. However, the sensed current may be subject to systematic measurement errors due to, for example, residual sensor offset, non-linearity, temperature drift, unstable voltage supply of the sensor, etc.

There are basically three different concepts for sensing the current in an AC/DC converter, namely (1) resistive current sensing followed by active filtering, (2) current transformer terminated with resistors or (3) a Hall-effect sensor with filters to reduce noise. Each concept has specific advantages and disadvantages, but one common problem is the mentioned systematic error, which deteriorates the current measurement particularly when the instantaneous value of the current to be measured is small (e.g. close to a zero-crossing of the sinusoidal current) or when the amplitude of the current is small.

The mentioned measurement error may not only lead to harmonic distortions but may cause even more severe problems such as reverse current injected into the AC power grid. Some PFC converter topologies may have diodes to prevent reverse current from being injected into the AC power grid. In some PFC converter concepts the diodes are replaced by power transistors (e.g. GaN or SiC transistors) to increase efficiency.

A common approach to increasing the accuracy of the current sensing is the calibration of the PFC converter towards the end of the manufacturing process (e.g. during a so-called end-of-line (EOL) test). This approach is time-consuming but effective in reducing the residual offset of the current sensing circuit. However, this approach does not address the problem of temperature drift. As a consequence, the current sensing accuracy may become significantly worse over time.

The problem solved by the invention described herein can thus be seen as the improvement of the current sensing in a PFC converter.

**SUMMARY**

The above-identified problem can be solved by the method of claim 1 and the circuit of claim 8. Various embodiments and further developments are covered by the dependent claims.

A method for an AC/DC converter is described herein. In accordance with one embodiment, the method includes determining duty cycle values for pulse width modulation (PWM) of a switching signal to operate the AC/DC converter with Power Factor Correction. Thereby, one duty cycle value is determined in each PWM cycle based on a measured current value that has been corrected using an offset value. The method further includes accumulating the duty cycle values throughout a positive half-wave of an AC input voltage of the AC/DC converter to obtain a first sum value and accumulating the duty cycle values throughout a negative half-wave of the AC input voltage of the AC/DC converter to obtain a second sum value. Furthermore, the method includes determining an error value representing the difference between the first sum value and the second sum value and adjusting the offset value based on the error value.

Moreover, a circuit is described herein that includes an AC/DC converter for Power Factor Correction with at least one electronic switch and an inductor, and a controller circuit. In accordance with one embodiment, the controller circuit is configured to determine duty cycle values for pulse width modulation (PWM) of a switching signal for driving the at least one switch, wherein a duty cycle value is determined in each PWM cycle based on a measured inductor current value that has been corrected using an offset value. The controller circuit is further configured to accumulate the duty cycle values throughout a positive half-wave of an AC input voltage of the AC/DC converter to obtain a first sum value and to accumulate the duty cycle values throughout a negative half-wave of the AC input voltage of the AC/DC converter to obtain a second sum value; Furthermore, the controller circuit is configured to determine an error value representing the difference between the first sum value and the second sum value and to adjust the offset value based on the error value.

## BRIEF DESCRIPTION OF THE DRAWINGS

The invention can be better understood with reference to the following drawings and descriptions. The components in the figures are not necessarily to scale; instead emphasis is placed upon illustrating the principles of the invention. Moreover, in the figures, like reference numerals designate corresponding parts. In the drawings:

Figure 1 is a graph showing an AC voltage of a PFC switching converter and the corresponding input current over time with an obvious zero-current offset current error; as a result of which an unbalanced input current can be observed.

Figure 2 is similar to Fig. 1 but with a very low zero-current offset current error and thus a well-balanced input current.

Figure 3 is a circuit diagram illustrating an example structure of a totem pole PFC converter.

Figure 4 illustrates an exemplary waveform of the inductor current passing through an inductor of a PFC converter.

Figure 5 is a flow chart illustrating one exemplary method for tuning the DC offset of the current measurement circuit of a PFC converter.

Figure 6 is a flow chart illustrating one example of how the offset value, which is used to correct the current measurement, may be tuned based on a calculated error value.

Figure 7 illustrates the circuit of Fig. 3 and a controller circuit that controls the switching operation of the PFC converter.

Figure 8 is a circuit diagram illustrating an example structure of a classical (single phase) boost PFC converter.

Figure 9 is a circuit diagram illustrating an example structure of a dual boost PFC converter.

## DETAILED DESCRIPTION

As mentioned in the introduction, PFC converters can be used to ensure a high power factor. This is accomplished by controlling the input current of the switching converter such that its sinusoidal waveform approximately corresponds to the sinusoidal waveform of the input voltage (provided by the public power grid) with only a very small (ideally zero) phase shift $\phi$ between input current and input voltage. The cosine of the phase angle $\phi$ is the power factor $\cos(\phi)$, wherein $\cos(\phi)=1$ (i.e. $\phi=0$) represents the desired ideal case. An accurate current sensing is needed in order to allow a precise controlling of the PFC converter's input current control. However, the sensed current may be subject to systematic measurement errors due to, for example, a residual sensor offset which causes a DC offset in the measured current signal.

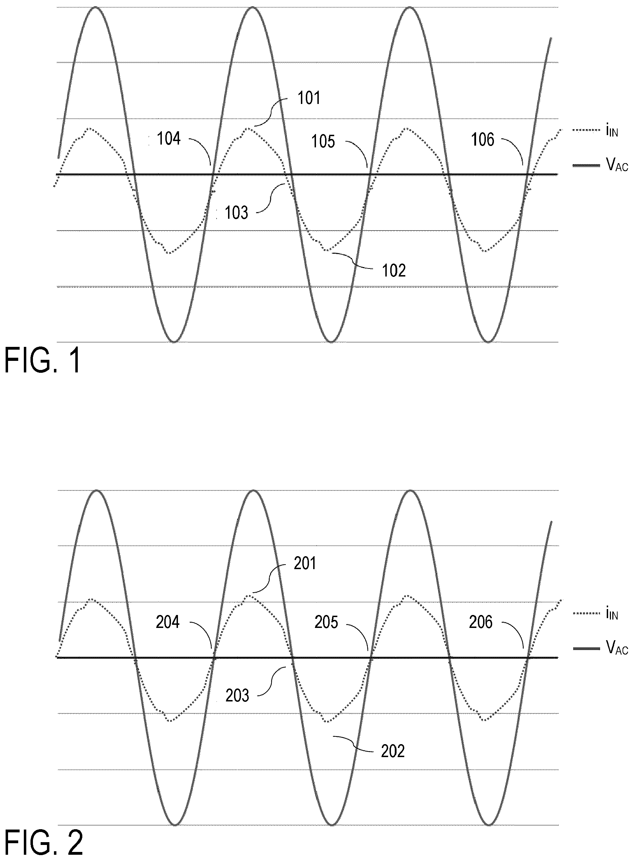

Fig. 1 illustrates an exemplary waveform of the input current $i_{IN}$ of a PFC converter. Fig. 1 shows the input current $i_{IN}$ when unbalanced. The positive peaks 101 have a smaller absolute value than the negative peaks 102. In the present example, the current total harmonic distortion $i_{THD}$ is around 20 percent, which is too large for high-end power converters.

Fig. 2 illustrates an exemplary waveform of a balanced input current $i_{IN}$ of a PFC converter, which is the desired (ideal) situation. Accordingly, the positive peaks 201 and the negative peaks 202 have the same absolute value.

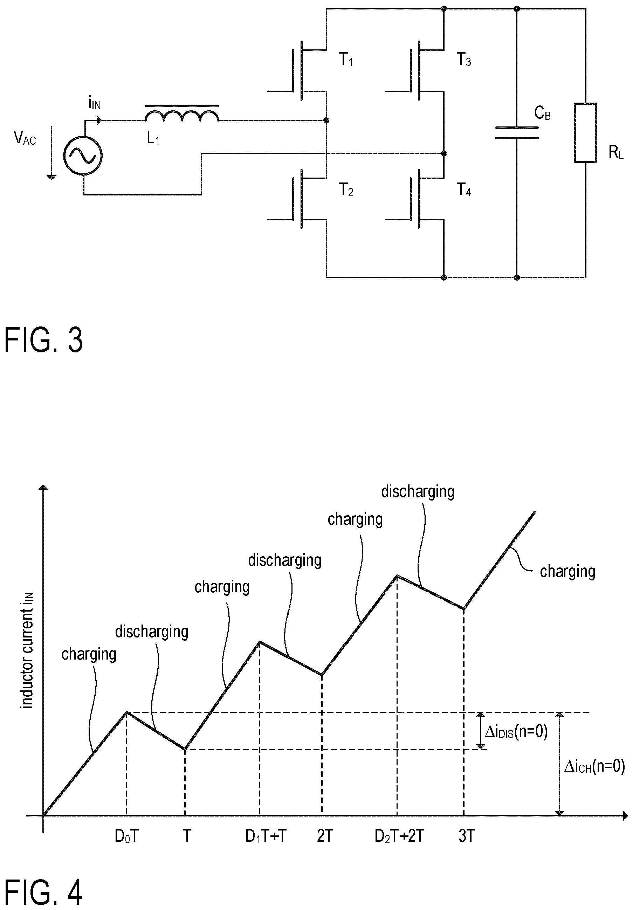

Fig. 3 is a circuit diagram illustrating an example structure of a totem pole PFC converter. Accordingly, the circuit includes a first transistor half-bridge composed of high-side transistor $T_1$ and low-side transistor $T_2$ and a second transistor half-bridge composed of high-side transistor $T_3$ and low-side transistor $T_4$. Any type of electronic switches may be used to implement the two half-bridges. For example, GaN high-electron-mobility transistors (HEMT) may be used as well as other types of field effect transistors such as MOSFETs or the like. The transistors $T_3$ and $T_4$ may also be replaced by diodes.

The middle taps of the two half-bridges are connected via an AC voltage source and an inductor Li. The AC voltage source represents the power grid and provides an alternating voltage $V_{AC}$. The DC output voltage $V_{OUT}$ is the voltage across an output capacitor $C_B$ which is connected parallel to the transistor half-bridges. The resistor $R_L$ represents an electric load connected to the PFC converter. The control signals for switching the transistors $T_1$-$T_4$ on and off may be generated by a controller circuit, wherein conventional gate driver circuits may be used to generate - based on the control signal - the gate signals which are actually applied to the gate electrodes of the transistors $T_1$-$T_4$. It is understood that the totem-pole topology of Fig. 3 is merely an illustrative example and the concepts described herein are also applicable to different circuit topologies (e.g. a single-phase (classical) PFC boost converter topology).

The controller circuit and the gate drivers are not shown in Fig. 3 in order to keep the drawings simple. Gate drivers are as such known and thus not further discussed herein in detail. The controller circuit may include one or more logic circuits for generating the control signals for the transistor half bridges such that the power factor remains close to one. The logic circuits may include one or more processors that are configured to execute software instructions stored in a memory in order to perform the functions and methods described herein. Alternatively or in addition thereto, the logic circuits may include hardwired logic circuits and/or programmable logic circuits. The controller circuit further includes (or is coupled to) circuitry for sensing the inductor current $i_{IN}$, the AC input voltage $V_{AC}$ and the DC output voltage $V_{OUT}$. The gathered information is used to generate the control signals for the transistor half-bridges.

In addition to the problem of harmonic distortion mentioned above, an inaccurate current measurement can lead to a reverse current. This means that current flows from the output capacitor $C_B$ (bulk capacitor) back to the power grid (represented by the AC voltage source in Fig. 3) via transistor $T_3$ and inductor Li during a positive half cycle of the AC input voltage $V_{AC}$, or that current flows from the power grid back to the output capacitor $C_B$ via transistor $T_4$ and inductor Li during a negative half cycle of the AC input voltage $V_{AC}$. Reverse currents can cause disturbances (voltage spikes) in the power grid. Referring to Fig. 1, reference numeral 103 designates a time span close to the zero-crossing of the AC input voltage $V_{AC}$, during which a negative current occurs while the AC input voltage $V_{AC}$ is still positive. A similar situation is marked by reference numerals 104, 105 and 106. In contrast, such situations do not occur in the case of a balanced input current as can be seen in Fig.2, reference numerals 203, 204, 205, and 206.

An unbalanced inductor current may be caused by a DC offset of the current sensing. To obviate this problem, the current measurement may be calibrated in an EOL test. However, as the DC offset may change over time and temperature, a singular calibration at the end of the manufacturing may be insufficient for some applications.

For the further discussion it is assumed that the PFC converter is operated in continuous conduction mode (CCM), wherein pulse-width modulation (PWM) is used to control consecutive charging and discharging phases. During the charging phases, energy stored in the inductor Li increases, whereas during the discharging phases, energy is transferred from the inductor Li to the output capacitor $C_B$.

Basically, the transistors $T_1$ to $T_4$ form - together with the inductor Li and the capacitor $C_B$ - a pair of boost converters. During the positive half-wave of the AC input voltage $V_{AC}$ (i.e. $V_{AC}>0$) the transistor $T_4$ is on (while Transistor $T_3$ is off), while transistors $T_1$ and $T_2$ are switched in accordance with a PWM signal, which may have a switching frequency $f_{PWM}$ of several kilohertz. During the charging phases, the transistor $T_2$ is on (while transistor $T_1$ is off) and, as a consequence, the inductor $i_{IN}$ current is positive and increasing. During the discharging phases, the transistor $T_1$ is on (while transistor $T_2$ is off) and, as a consequence, the inductor $i_{IN}$ current is positive but decreasing, while energy is transferred from the inductor Li to the output capacitor (via transistor $T_1$ and $T_4$).

The roles of the transistors interchange when the polarity of the AC input voltage $V_{AC}$ changes. During the negative half-wave of the AC input voltage $V_{AC}$ (i.e. $V_{AC}<0$) the transistor $T_3$ is on (while Transistor $T_4$ is off), while transistors $T_1$ and $T_2$ are switched in accordance with the PWM signal. During the charging phases, the transistor $T_1$ is on (while transistor $T_2$ is off) and, as a consequence, the inductor $i_{IN}$ current is negative and decreasing (while the stored energy increases). During the discharging phases, the transistor $T_2$ is on (while transistor $T_1$ is off) and, as a consequence, the inductor $i_{IN}$ current is negative but increasing, while energy is transferred from the inductor Li to the output capacitor (via transistor $T_2$ and $T_3$). The duty cycle $D_n$ of the PWM signal is updated in each PWM switching cycle (the index n denotes the PWM switching cycle). The charging phase of the $n^{th}$ cycle has a duration of $T_{ON}=D_n/f_{PWM}$ whereas the discharging phase of the $n^{th}$ cycle has a duration of $(1-D_n)/f_{PWM}$. The duty cycle $D_n$ is a number between 0 and 1 (and sometimes expressed in percent).

Concepts for calculating updated duty cycle values are as such known and thus not discussed herein in detail. Generally, the current duty cycle $D_n$ is determined based on measured values of the AC input voltage $V_{AC}$, the DC output voltage $V_{OUT}$ and the inductor current $i_{IN}$. Accordingly, three sensors (sensing circuit) are included in a PFC converter in order to enable the control of the power factor. One sensor is configured to sense the AC input voltage $V_{AC}$ (grid voltage), a second sensor is configured to sense the inductor current $i_{IN}$, and a third sensor is configured to sense the output voltage $V_{OUT}$ across the capacitor $C_B$.

The charging and the discharging phases are illustrated in Fig. 4, which illustrates an exemplary waveform of the inductor current $i_{IN}$ throughout the first three PWM cycles (n=1, 2, 3, ...) of a positive half-wave of the AC input voltage $V_{AC}$. In Fig. 4, $D_0$ denotes the duty cycle value in the first PWM cycle (n=0), $D_1$ denotes the duty cycle value in the second PWM cycle (n=1), $D_2$ denotes the duty cycle value in the third PWM cycle (n=2), etc.

The voltage swing $\Delta i_{CH}$ during the charging phase of the $n^{th}$ PWM cycle can be calculated as

$$\Delta i_{CH}[n] = D_n \cdot V_{IN}[n]/(f_{PWM} \cdot L_1), \tag{1}$$

while the voltage swing $\Delta i_{DIS}$ during a discharging phase of the $n^{th}$ PWM can be calculated as

$$\Delta i_{DIS}[n] = (1 - D_n) \cdot (V_{IN}[n] - V_{OUT}[n])/(f_{PWM} \cdot L_1), \tag{2}$$

wherein $V_{IN}[n]$ denotes the rectified AC input voltage, i.e. $V_{IN}=|V_{AC}|$ in the $n^{th}$ PWM cycle. $V_{OUT}[n]$ denotes the output voltage in the $n^{th}$ PWM cycle. As can be seen from the above equations, the voltage swing in the charging phases are proportional to the corresponding duty cycle $D_n$. The voltage swings in the discharging phases are proportional to the corresponding inverse duty cycle $1 - D_n$.

Because the inductor current $i_{IN}$ is a periodic AC signal, the following condition must be fulfilled:

$$\sum_{n=0}^{N-1}(\Delta i_{CH}[n] + \Delta i_{DIS}[n]) = 0. \tag{3}$$

However, inaccurate current sensing (due to a zero offset in the current sensor) may cause an unbalanced inductor current as illustrated in Fig. 1. A fully balanced inductor current as shown in Fig. 2 will have equal RMS values $I_{RMS}^+$ and $I_{RMS}^-$ in the positive and the negative half-wave. These RMS values are given by the following equations:

$$I_{RMS}^+ = \sqrt{\frac{2}{N}\sum_{n=0}^{N/2-1}(\Delta i_{CH}[n] + \Delta i_{DIS}[n])^2}, \text{ and} \tag{4}$$

$$I_{RMS}^- = \sqrt{\frac{2}{N}\sum_{n=N/2}^{N-1}(\Delta i_{CH}[n] + \Delta i_{DIS}[n])^2}. \tag{5}$$

It can be seen from equations 1-2 and 4-5 that the RMS values $I_{RMS}^+$ and $I_{RMS}^-$ can be calculated from the values of the duty cycle $D_n$ and the corresponding voltage values $V_{IN}[n]$ and $V_{OUT}[n]$. The inductance of the inductor Li and the PWM frequency $f_{PWM}$ are constants. A measured inductor current value is not required for the calculation of the RMS values.

According to the concept described herein, the offset of the current sensor can be tuned such that the RMS values $I_{RMS}^+$ and $I_{RMS}^-$ become equal in order to achieve a balanced inductor current. However, calculating the RMS values in each period of the AC may be too time consuming for a microcontroller in a practical application. In addition, the inductance Li may not be constant but rather somewhat lower for higher current values. When taking into account a non-linear inductance, the computation of the RMS values may become even more complicated. However, using the symmetry of a sine wave (e.g. sin(a) = -sin(-a)) it can be derived from the above equations that duty cycles $D_n$ accumulated over one half-wave are proportional to the respective RMS value. In accordance with some embodiments described herein, the accumulated duty cycles $D_{ACC}^+$ and $D_{ACC}^-$ (sum values) may be calculated as shown in the following equations:

$$D_{ACC}^+ = \sum_{n=0}^{N/2-1} D_n, \text{ and} \tag{6}$$

$$D_{ACC}^- = \sum_{n=N/2}^{N-1} D_n. \tag{7}$$

As mentioned further above, the PWM cycle numbers 0 to N/2-1 cover the positive half-wave of each period $T_{AC}$ of the AC input voltage $V_{AC}$ and the PWM cycle numbers N/2 to N-1 cover the subsequent negative half-wave. Consequently, the PWM frequency $f_{PWM}$ equals $N/T_{AC}$, wherein $T_{AC}=20$ ms for 50 Hz power grids. For example, N=2000 results in a PWM frequency of $f_{PWM}=100$ kHz.

The accumulated duty cycle values $D_{ACC}^+$ and $D_{ACC}^-$ can be calculated at the end of each positive or, respectively, negative half-wave of the AC input voltage $V_{AC}$. To balance the inductor current $i_{IN}$ (as shown e.g. in Fig.

2), the DC offset $\Delta i_{OS}$ of the current sensing circuit is tuned such that the two latest values of $D_{ACC}^{+}$ and $D_{ACC}^{-}$ are approximately equal. This tuning of the DC offset $\Delta i_{OS}$ may be an iterative process which can be performed during the normal operation of the PFC converter.

To keep the explanations above simple, it was assumed that the PFC converter operates in CCM. However, the concepts described herein are also applicable in Discontinuous Conduction Mode (DCM) and Critical Conduction Mode (CrCM). The concept for tuning the offset of the current sensing circuit in order to balance the AC input current (inductor current) is applicable to all PFC converters that use a current feedback to determine the duty cycle of the switching signal.

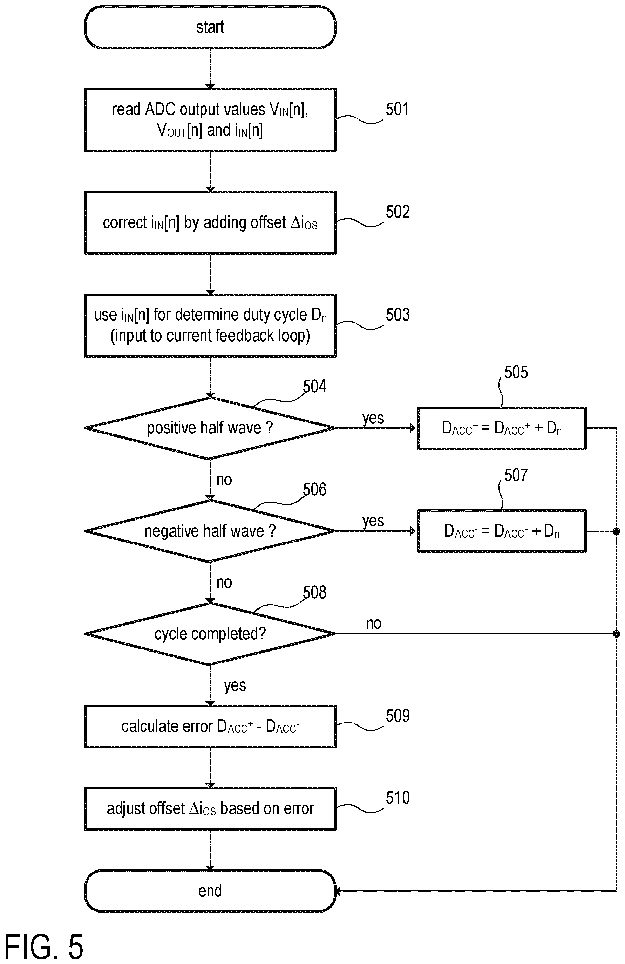

For the further discussion it is assumed that the values $V_{IN}[n]$ and $V_{OUT}[n]$ are measured (sampled and digitized) voltage values obtained using an analog-to-digital converter. A measured value $i_{IN}[n]$ of the inductor current may also be obtained using a current sense circuit with an analog-to-digital converter, wherein the measured value $i_{IN}[n]$ may include an adjustable DC offset $\Delta i_{OS}$. To tune the DC offset $\Delta i_{OS}$, the controller circuit of the PFC converter may repetitively (e.g. in each PWM switching cycle) perform an algorithm, an example of which is illustrated by the flow chart of Fig. 5. In practice, the algorithm may be implemented as an interrupt routine performed by a microcontroller, which may be included in the controller circuit of the PFC converter.

According to Fig. 5, each time the routine is called, the current digitized values $V_{IN}[n]$, $V_{OUT}[n]$ and $i_{IN}[n]$ are obtained from the respective sensor circuits, e.g. from the output registers of respective analog-to-digital converters (see Fig. 5, step 501). As discussed above, the measured current value $i_{IN}[n]$ may include a systematic error, which is corrected by adding an offset value $\Delta i_{OS}$ (see Fig. 5, step 502). As an initial value, the offset value $\Delta i_{OS}$ may be set to zero. In the present embodiment, the corrected inductor current value is then used to determine the duty cycle $D_n$ for the current PWM cycle n (see Fig. 5, step 503). In other words, the corrected inductor current value is used as feedback signal input to the control loop that outputs the current duty cycle $D_n$ as control variable (wherein the inductor current $i_{IN}$ is the controlled variable).

The following steps 504 to 510 are performed for modifying the offset value $\Delta i_{OS}$ in order to achieve a balanced inductor current $i_{IN}$ as shown, e.g., in Fig. 2. In step 504 the condition $V_{AC}>0$ is tested, which results in "yes" during a positive half-wave of the AC input voltage. In this event, the current duty cycle $D_n$ is added to $D_{ACC}^{+}$ (step 505). In step 506 the condition $V_{AC}<0$ is tested, which results in "yes" during a negative half-wave of the AC input voltage. In this event, the current duty cycle $D_n$ is added to $D_{ACC}^{-}$ (step 507). The variables $D_{ACC}^{+}$ and $D_{ACC}^{-}$ may be initialized as zero at the beginning of a period (or the end of the preceding period) of the AC input voltage. The end of the current period of the AC input voltage (e.g. at the end of the negative half-wave) can be detected using a zero-crossing detection (step 508). Dependent on the actual embodiment, different approaches to detecting the end of the AC cycle may be used.

At the end of a period of the AC input voltage (AC cycle), an error value E is determined as the difference between the two accumulated duty cycle values $D_{ACC}^{+}$ and $D_{ACC}^{-}$, i.e. $E = D_{ACC}^{+} - D_{ACC}^{-}$ (see Fig. 5, step 509). In step 510, the current offset value $\Delta i_{OS}$ is modified/adjusted based in the error value E. Step 510 may also include the reset of the values $D_{ACC}^{+}$ and $D_{ACC}^{-}$ to their initial values.

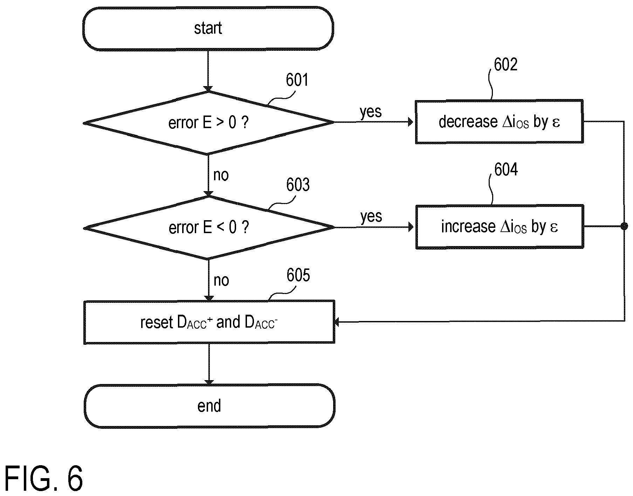

The flow chart of Fig. 6 illustrates one example of how step 509 of Fig. 5 may be implemented to actually adjust/fine-tune - based on the error E - the DC offset value $\Delta i_{OS}$, which is used to correct the measured inductor current values $i_{IN}[n]$. Accordingly, in step 601 the condition $E>0$ is tested. That is, step 601 yields "yes" if the error value E is positive. In this case, the offset value $\Delta i_{OS}$ is increased by a small amount $\varepsilon$ ($\Delta i_{OS}=\Delta i_{OS}+\varepsilon$, step 602). In step 603 the condition $E<0$ is tested. That is, step 603 yields "yes" if the error value E is negative. In this case, the offset value $\Delta i_{OS}$ is decreased by a small amount $\varepsilon$ ($\Delta i_{OS}=\Delta i_{OS}-\varepsilon$, step 604). In the event that the error value E is zero, the offset value $\Delta i_{OS}$ is left unchanged. Finally, the accumulated duty cycle values $D_{ACC}^{+}$ and $D_{ACC}^{-}$ are reset (step 605) before the next AC cycle begins.

It is noted that, in one embodiment, the zero threshold in steps 601 and 603 may be replaced by small finite values. For example, the condition tested in step 601 may be $E>a$ (instead of $E>0$), and the condition tested in step 603 may be $E<-a$ (instead of $E<0$), wherein $a$ may be a small positive value. This approach avoids an adjustment of the offset value $\Delta i_{OS}$ if the error is small and within the interval $[-a, a]$.

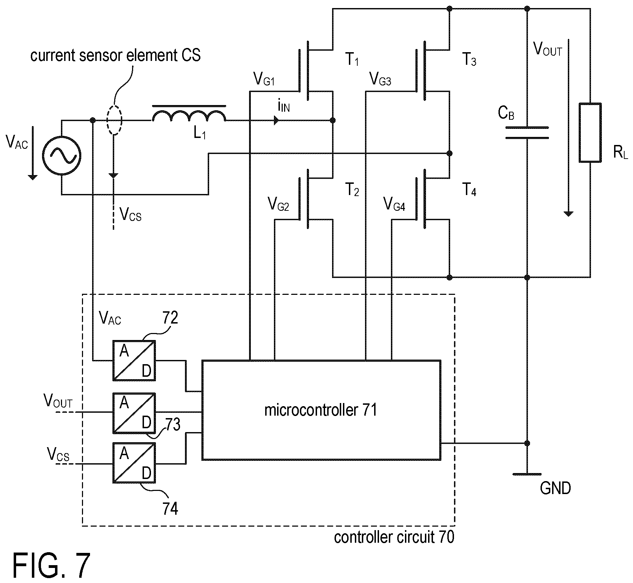

Fig. 7 illustrates one exemplary embodiment, which includes the totem pole PFC converter circuit of Fig. 3 and a corresponding controller circuit 70, and which is configured to control the switching operation of the PFC converter and to perform the steps illustrated in Figs. 5 and 6. To the extent that the components of Fig. 6 are also included in Fig. 3, reference is made to the above description of Fig. 3. The controller circuit 70 includes, in the present example, a microcontroller 71 as well as the analog-to-digital converters 72, 73, and 74. It is understood that the analog-to-digital converters may be part of the microcontroller's peripheral circuitry and may be integrated in the same semiconductor chip as the microcontroller.

The analog-to-digital converters may be regarded as sensor circuits (or as parts of sensor circuits) that are configured to repetitively generate measured values of the AC input voltage $V_{AC}$, the output voltage $V_{OUT}$ and the inductor current $i_{IN}$. In the present example, the sensor circuit for measuring the inductor current includes a current sensor element CS, which may be, for example, a Hall sensor, wherein the sensor voltage Vcs provided by the sensor element CS represents the inductor current $i_{IN}$. It is understood that various other concepts for sensing the inductor current may be applicable instead of a Hall sensor. For example, some of the transistor cells of transistors $T_1$ and $T_2$ may be used to sense the transistor currents when the non-zero transistor current is equal to the inductor current $i_{IN}$. However, such concepts are well known in the field of switching converters and thus not further discussed herein.

As mentioned above, the microcontroller 71 may include one or more processors that are configured to execute software instructions stored in a memory (which may also be part of the microcontroller 71). The microcontroller 71 may receive a system clock signal from which the PWM cycle period $1/f_{PWM}$ may be derived. The above-mentioned control loop (see Fig. 5, step 503), which determines the duty cycle $D_n$, may be implemented using the software stored in the memory. Suitable control algorithms are as such known and thus not further discussed herein. What is important is that the control loop takes the corrected inductor current value $i_{IN}[n]$ as an input, and that the offset value $\Delta i_{OS}$, which is used to correct the measured inductor current, is regularly (periodically or from time to time) adjusted as described above with reference to Figs. 5 and 6.

It is understood that Fig. 7 is a simplified example which only includes those components that are relevant to the explanation of the embodiments. Standard components such as voltage regulators, gate driver circuits, etc. have been omitted to keep the focus on the relevant parts. Furthermore, it is emphasized that the method steps illustrated in Fig. 5 and 6 need not necessarily be executed in the depicted order. The skilled person will readily understand that various steps can be rearranged without changing the underlying concept of correcting the DC offset of the measured inductor current based on the duty cycles $D_n$ occurring during one AC cycle.

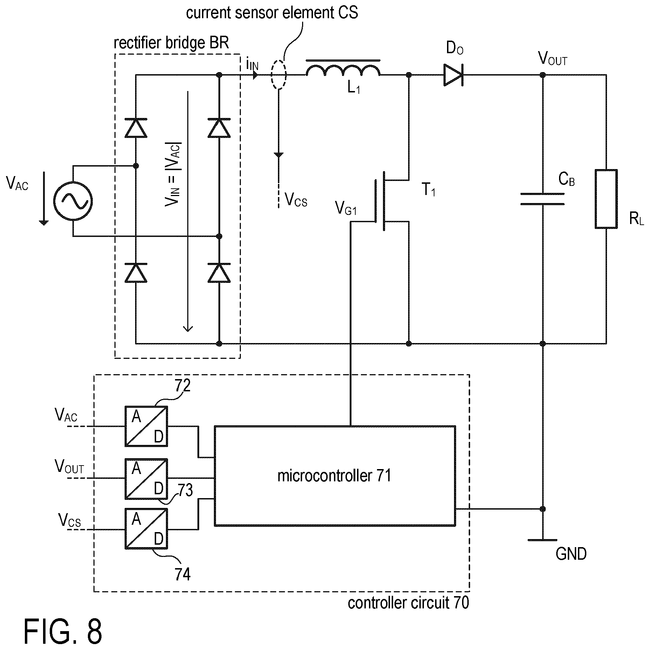

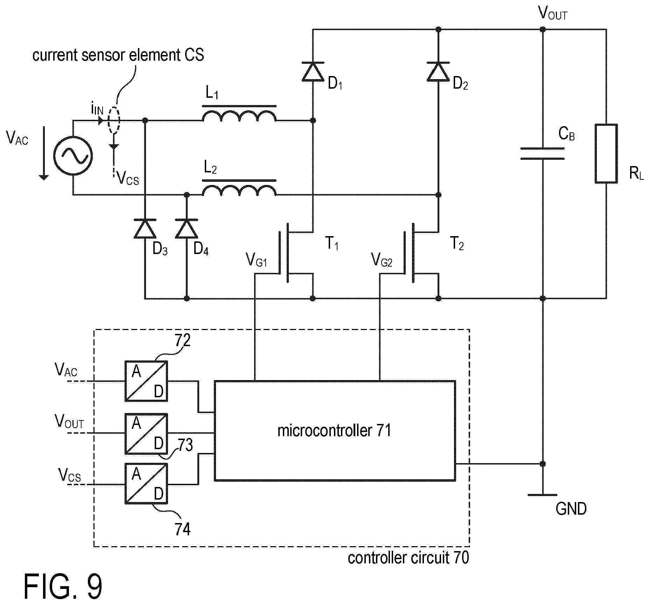

In Fig. 7, a totem-pole PFC converter topology is used. As mentioned, this is only an example and other converter topologies may be applicable instead. Fig. 8 illustrates a similar circuit as Fig. 7, wherein a classical (single-phase) boost PFC converter topology is used instead of the totem-pole PFC converter topology. In the example of Fig. 9, a dual boost PFC converter topology is used. These converter topologies are as such known and are discussed herein merely to show that the concept of adjusting the offset of the current sensing described herein can readily applied to various converter topologies.

In the example of Fig. 8, the PCF converter includes a full-bridge rectifier BR and a boost stage. The full-bridge rectifier BR is composed of four diodes coupled between the AC voltage source (providing the AC input voltage $V_{AC}$) and the boost stage. The boost stage is composed of the inductor Li, the electronic switch $T_1$ (e.g. a MOSFET), the diode $D_O$ and the output capacitor $C_B$, which provides the DC output voltage $V_{OUT}$. The controller circuit 70 is basically the same as in the previous example and reference is made to the respective description above. Different to the example of Fig. 7, only one pulse-width modulated control signal $V_{G1}$ (gate signal of transistor $T_1$) is needed to control the switching operation of the boost stage. However, the duty cycle values $D_n$ may be generated - for each PWM cycle and based on measured values $i_{IN}[n]$ (represents current sense signal $V_{CS}$), $V_{IN}[n]$ (represents rectified AC input signal $V_{AC}$) and $V_{OUT}[n]$ - in the same way as in the previous example, in which a totem-pole PFC converter topology has been used.

In the example of Fig. 9, the first inductor Li, the first transistor $T_1$, the first diode $D_1$ and the output capacitor $C_B$ form a first boost converter, and the second inductor $L_2$, the second transistor $T_2$, the second diode $D_2$ and the (same) output capacitor $C_B$ form a second boost converter.

The first boost converter is only active during the positive half-wave of the AC input voltage $V_{AC}$ and the second boost converter is only active during the negate half-wave. The circuit is closed via diode $D_3$ (in the negative half-wave) and, respectively, via diode $D_4$ (in die positive half-wave). The inductor current $i_{IN}$ may be sensed between the AC voltage source and the common circuit node of inductor Li and diode $D_3$. Accordingly, the sensed current values $i_{IN}[n]$ represent the current passing through inductor Li (and diode $D_4$) during the positive half-wave and, respectively, the passing current through inductor $L_2$ (and diode $D_3$) during the negative half-wave.

Different to the example of Fig. 7, one pulse-width modulated control signal $V_{G1}$ (gate signal of transistor $T_1$) is needed to control the switching operation of the dual boost stage during the positive half-wave and one pulse-width modulated control signal $V_{G2}$ (gate signal of transistor $T_2$) is needed to control the switching operation of the dual boost stage during the negative half-wave. However, the duty cycle values $D_n$ may be generated - for each PWM cycle and throughout a whole AC cycle and based on measured values $i_{IN}[n]$ (represents current sense signal $V_{CS}$), $V_{IN}[n]$ (represents rectified AC input signal $V_{AC}$) and $V_{OUT}[n]$ - in the same way as in the first example, in which a totem-pole PFC converter topology has been used.

Some important aspects of the embodiments described above are summarized below. It is emphasized, however, that the following is not an exhaustive enumeration but rather an exemplary summary. One embodiment relates to a method that may be performed by a controller circuit for an AD/DC switching converter. Accordingly, the method includes determining duty cycle values $D_n$ for the pulse width modulation (PWM) of one or more switching signals (see, e.g. Figs. 7-9, gate signal $V_{G1}$ and, as the case may be, gate signal $V_{G2}$) to operate the AC/DC converter with Power Factor Correction. For this purpose, one duty cycle value $D_n$ is determined in each PWM cycle based on a measured current value (current feedback loop) that has been corrected using an offset value $\Delta i_{OS}$. The method further includes accumulating the duty cycle values $D_n$ throughout a positive half-wave of an AC input voltage of the AC/DC converter to obtain a first sum value $D_{ACC}^{+}$ and accumulating the duty cycle values $D_n$ throughout a negative half-wave of the AC input voltage of the AC/DC converter to obtain a second sum value $D_{ACC}^{-}$ (cf. Fig. 5). Furthermore, the method includes determining an error value $E$ representing the difference between the first sum value and the second sum value and adjusting the offset value $\Delta i_{OS}$ based on the error value.

In order to achieve a proper Power Factor Correction, the duty cycle values $D_n$ are to be determined such that the inductor current (input current) is at least approximately in phase with the AC input voltage of the AC/DC converter (see, e.g. Fig. 2). The feedback loop may receive additional input data in addition to the measured inductor current. In one example. a duty cycle value $D_n$ is determined - in each PWM cycle - based on the corrected current value $i_{IN}[n]$, a first measured voltage value $V_{IN}[n]$ representing the AC input voltage of the AC/DC converter, and a second measured voltage value $V_{OUT}[n]$ representing the DC output voltage of the AC/DC converter.

In one embodiment adjusting the offset value $\Delta i_{OS}$ includes decreasing the offset value $\Delta i_{OS}$ in the event that the error value is greater than a first threshold ($E > a$) and increasing the offset value $\Delta i_{OS}$ in the event that the error value is lower than a second threshold ($E < -a$). The first and the second thresholds may be both zero, and the offset value may remain unchanged in the event that the error value is zero or between the thresholds ($-a \leq E \leq a$).

In one embodiment, the first and the second sum values are reset to respective initial or reference values in each period of the AC input voltage. However, this is not necessarily the case. This initial values may be zero.

Another embodiment relates to a controller circuit for an AD/DC converter. Accordingly, the controller circuit comprises a processor (e.g. the microcontroller 71 as shown in Fig. 7-9) and memory (e.g. included in the microcontroller) storing instructions that, when executed by the processor, cause controller circuit to perform the method steps and functions summarized above and depicted, e.g. in Figs. 5 and 6. Of course the processor may use some peripheral circuit components (which may also be included in the microcontroller) such as analog-to-digital converters to perform the desired function.

A further embodiment relates to a circuit arrangement comprising an AC/DC converter for Power Factor Correction which includes at least one electronic switch and an inductor, and a controller circuit for the AC/DC converter. In accordance with one embodiment, the controller circuit is configured to determine duty cycle values $D_n$ for pulse width modulation (PWM) of a switching signal for driving the at least one switch (see, e.g. Figs. 7-9, gate signal $V_{G1}$ and, as the case may be, gate signal $V_{G2}$), wherein a duty cycle value is determined in each PWM cycle based on (current feedback loop) a measured inductor current value that has been corrected using an offset value $\Delta i_{OS}$. The controller circuit is further configured to accumulate the duty cycle values $D_n$ throughout a positive half-wave of an AC input voltage of the AC/DC converter to obtain a first sum value $D_{ACC}^{+}$ and to accumulate the duty cycle values throughout a negative half-wave of the AC input voltage of the AC/DC converter to obtain a second sum value $D_{ACC}^{-}$ (cf. Fig. 5). Furthermore, the controller circuit is configured to determine an error value $E$ representing the difference between the first sum value and the second sum value and to adjust the offset value $\Delta i_{OS}$ based on the error value.

Although the invention has been illustrated and described with respect to one or more implementations, alterations and/or modifications may be made to the illustrated examples without departing from the spirit and scope of the appended claims. In particular regard to the various functions performed by the above described components or structures (units, assemblies, devices, circuits, systems, etc.), the terms (including a reference to a "means") used to describe such components are intended to correspond - unless otherwise indicated - to any component or structure, which performs the specified function of the described component (e.g., that is functionally equivalent), even though not structurally equivalent to the disclosed structure, which performs the function in the herein illustrated exemplary implementations of the invention.

**Claims**

1. A method comprising:

   determining duty cycle values ($D_n$) for pulse width modulation, PWM, of a switching signal to operate an AC/DC converter with Power Factor Correction, wherein one duty cycle value ($D_n$) is determined in each PWM cycle based on a measured current value ($i_{IN}[n]$) that has been corrected using an offset value ($\Delta i_{OS}$);
   accumulating the duty cycle values ($D_n$) throughout a positive half-wave of an AC input voltage ($V_{AC}$) of the AC/DC converter to obtain a first sum value $(D^+_{ACC})$;
   accumulating the duty cycle values ($D_n$) throughout a negative half-wave of the AC input voltage ($V_{AC}$) of the AC/DC converter to obtain a second sum value $(D^-_{ACC})$;
   determining an error value ($E$) representing the difference between the first sum value $(D^+_{ACC})$ and the second sum value $(D^-_{ACC})$; and
   adjusting the offset value ($\Delta i_{OS}$) based on the error value.

2. The method of claim 1, wherein adjusting the offset value ($\Delta i_{OS}$) comprises:

   decreasing the offset value ($\Delta i_{OS}$) in the event the error value ($E$) is greater than a first threshold ($a$), and increasing the offset value ($\Delta i_{OS}$) in the event the error value ($E$) is lower than a second threshold (-$a$).

3. The method of claim 2,

   wherein first and the second thresholds are both zero, and
   wherein the offset value ($\Delta i_{OS}$) remains unchanged in the event that the error value ($E$) is zero.

4. The method of any of claims 1 to 3, further comprising:

   resetting the first sum value $(D^+_{ACC})$ and the second sum value $(D^-_{ACC})$ to respective initial values in each period of the AC input voltage ($V_{AC}$).

5. The method of any of claims 1 to 4,
   wherein - in each PWM cycle - a duty cycle value ($D_n$) is determined based on the corrected measured current value ($i_{IN}[n]$), a first measured voltage value ($V_{IN}[n]$) representing the AC input voltage ($V_{AC}$). of the AC/DC converter, and a second measured voltage value ($V_{OUT}[n]$) representing the DC output voltage of the AC/DC converter.

6. The method of any of claims 1 to 5,
   wherein the duty cycle values ($D_n$) are determined such that the inductor current ($i_{IN}$) is approximately in phase with the AC input voltage ($V_{AC}$).

7. The method of any of claims 1 to 6,
   wherein the AC/DC converter comprises a single-phase boost PFC converter or a dual boost PFC converter topology or a totem-pole PFC converter topology.

8. A circuit comprising:

   an AC/DC converter for Power Factor Correction including at least one electronic switch (Ti) and an inductor (Li);
   a controller circuit coupled to the AC/DC converter and configured to:

   determine duty cycle values ($D_n$) for pulse width modulation, PWM, of a switching signal ($V_{G1}$) for driving the at least one switch ($T_1$), wherein a duty cycle value ($D_n$) is determined in each PWM cycle based on a measured inductor current value ($i_{IN}[n]$) that has been corrected using an offset value ($\Delta i_{OS}$)

   accumulate the duty cycle values ($D_n$) throughout a positive half-wave of an AC input voltage ($V_{AC}$) of the AC/DC converter to obtain a first sum value $(D_{ACC}^{+})$;
accumulate the duty cycle values ($D_n$) throughout a negative half-wave of the AC input voltage ($V_{AC}$) of the AC/DC converter to obtain a second sum value $(D_{ACC}^{-})$;
determine an error value ($E$) representing the difference between the first sum value $(D_{ACC}^{+})$ and the second sum value $(D_{ACC}^{-})$; and
adjust the offset value ($\Delta i_{OS}$) based on the error value ($E$).

9. The circuit of claim 8, wherein, to adjust the offset value ($\Delta i_{OS}$), the controller circuit is configured to:

   decrease the offset value ($\Delta i_{OS}$) in the event the error value ($E$) is greater than a first threshold ($a$), and
   increase the offset value ($\Delta i_{OS}$) in the event the error value ($E$) is lower than a second threshold ($-a$).

10. The circuit of claim 9,

    wherein first and the second thresholds are both zero, and
    wherein the offset value ($\Delta i_{OS}$) remains unchanged in the event that the error value ($E$) is zero.

11. The circuit of any of claims 8 to 10, wherein the controller circuit (70) is further configured to:

    reset the first sum value $(D_{ACC}^{+})$ and the second sum value $(D_{ACC}^{-})$ to respective initial values in each period of the AC input voltage ($V_{AC}$).

12. The circuit of any of claims 8 to 11, wherein, to determine duty cycle values ($D_n$), the controller circuit (70) is further configured to:
    determine - in each PWM cycle - a duty cycle value ($D_n$) based on the corrected measured current value ($i_{IN}[n]$), a first measured voltage value ($V_{IN}[n]$) representing the AC input voltage ($V_{AC}$). of the AC/DC converter, and a second measured voltage value ($V_{OUT}[n]$) representing the DC output voltage of the AC/DC converter.

13. The circuit of any of claims 8 to 12,
    wherein the duty cycle values ($D_n$) are determined such that the inductor current ($i_{IN}$) is approximately in phase with the AC input voltage ($V_{AC}$).

14. The circuit of any of claims 8 to 13,
    wherein the AC/DC converter comprises a single-phase boost PFC converter or a dual boost PFC converter topology or a totem-pole PFC converter topology.

15. A controller circuit for an AC/DC converter, the controller circuit comprising:

    a processor (71); and
    memory storing instructions that, when executed by the processor (71), cause controller circuit to perform the method of any one of claims 1 to 7.

FIG. 1

FIG. 2

FIG. 3

FIG. 4

FIG. 5

FIG. 6

FIG. 7

current sensor element CS

rectifier bridge BR

$V_{AC}$

$V_{IN} = |V_{AC}|$

$i_{IN}$

$V_{CS}$

$L_1$

$D_0$

$V_{OUT}$

$V_{G1}$

$T_1$

$C_B$

$R_L$

72

$V_{AC}$ — A/D

$V_{OUT}$ — A/D 73

$V_{CS}$ — A/D

74

microcontroller 71

GND

controller circuit 70

FIG. 8

FIG. 9

Europäisches
Patentamt

European
Patent Office

Office européen
des brevets

# EUROPEAN SEARCH REPORT

**Application Number**

EP 22 19 9709

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | JP 5 874019 B2 (PANASONIC CORP) 1 March 2016 (2016-03-01) * paragraphs [0004], [0013], [0025], [0050], [0067], [0068]; figures 1,4A, 4B, 5, 7B * | 1-15 | INV. H02M3/156 H02M1/42 H02M1/32 H03K5/156 |
| Y | CN 201 611 786 U (NANJING GLARUN POWER ELECTRONIC CO LTD) 20 October 2010 (2010-10-20) * abstract; figure 2 * | 1,8,15 | |
| Y | US 6 981 185 B1 (DAVIS BARRY ALLEN [US] ET AL) 27 December 2005 (2005-12-27) * column 5, lines 12-25; claim 15; figures 3,4, * | 1,4,8, 11,15 | |
| Y | CN 108 879 630 A (CRRC YONGJI ELECTRIC CO LTD) 23 November 2018 (2018-11-23) * abstract; figure 2 * | 1-3, 8-10,15 | |
| Y | EP 2 197 250 A1 (IWASAKI ELECTRIC CO LTD [JP]) 16 June 2010 (2010-06-16) * paragraphs [0031], [0053] - [0055], [0059], [0080], [0107]; figures 3,4,6A, 6B, 8A,8B,12 * | 5-7, 12-14 | TECHNICAL FIELDS SEARCHED (IPC) H02M H03K |
| Y A | GB 2 019 141 A (HITACHI LTD) 24 October 1979 (1979-10-24) * page 2, lines 13-26; figures 2C,2D * | 2 1,8,15 | |

The present search report has been drawn up for all claims

| Place of search | Date of completion of the search | Examiner |
|---|---|---|
| The Hague | 24 February 2023 | Kanelis, Konstantin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

...........................................................................
& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 22 19 9709

This annex lists the patent family members relating to the patent documents cited in the above-mentioned European search report.
The members are as contained in the European Patent Office EDP file on
The European Patent Office is in no way liable for these particulars which are merely given for the purpose of information.

24-02-2023

| Patent document cited in search report | | Publication date | Patent family member(s) | | Publication date |
|---|---|---|---|---|---|
| JP 5874019 | B2 | 01-03-2016 | CN | 103229407 A | 31-07-2013 |
| | | | JP | 5874019 B2 | 01-03-2016 |
| | | | JP | WO2012070200 A1 | 19-05-2014 |
| | | | WO | 2012070200 A1 | 31-05-2012 |
| CN 201611786 | U | 20-10-2010 | NONE | | |
| US 6981185 | B1 | 27-12-2005 | NONE | | |
| CN 108879630 | A | 23-11-2018 | NONE | | |
| EP 2197250 | A1 | 16-06-2010 | CA | 2698278 A1 | 02-04-2009 |
| | | | CN | 101790900 A | 28-07-2010 |
| | | | EP | 2197250 A1 | 16-06-2010 |
| | | | JP | 4640624 B2 | 02-03-2011 |
| | | | JP | 4645994 B2 | 09-03-2011 |
| | | | JP | 4670109 B2 | 13-04-2011 |
| | | | JP | 2011003556 A | 06-01-2011 |
| | | | JP | 2011003557 A | 06-01-2011 |
| | | | JP | WO2009041367 A1 | 27-01-2011 |
| | | | US | 2010157257 A1 | 24-06-2010 |
| | | | WO | 2009041367 A1 | 02-04-2009 |
| GB 2019141 | A | 24-10-1979 | DE | 2915138 A1 | 18-10-1979 |
| | | | GB | 2019141 A | 24-10-1979 |
| | | | JP | S5827907 B2 | 13-06-1983 |
| | | | JP | S54134936 A | 19-10-1979 |
| | | | NL | 7902818 A | 16-10-1979 |

EPO FORM P0459

For more details about this annex : see Official Journal of the European Patent Office, No. 12/82